# EUROPEAN PATENT APPLICATION

(11) **EP 2 139 031 A1**
(43) Date of publication of application: **30.12.2009**
(21) Application number: 08872677.3
(22) Date of filing: 03.10.2008
(51) Int. Cl.: H01L 21/338, H01L 21/28, H01L 21/337, H01L 29/04, H01L 29/201, H01L 29/778, H01L 29/78, H01L 29/808, H01L 29/812

(54) **SEMICONDUCTOR DEVICE AND METHOD FOR MANUFACTURING SEMICONDUCTOR DEVICE**

(30) Priority: 22.02.2008 JP 2008041741
(71) Applicant: Sumitomo Electric Industries, Ltd., Osaka-shi, Osaka 541-0041 (JP)
(72) Inventor: FUJIKAWA, Kazuhiro, Osaka-shi Osaka 554-0024 (JP); HARADA, Shin, Osaka-shi Osaka 554-0024 (JP)
(74) Representative: Grünecker, Kinkeldey, Stockmair & Schwanhäusser Anwaltssozietät
(86) International application number: PCT/JP2008/068013
(87) International publication number: WO 2009/104299

(57) **Abstract**

A substrate composed of hexagonally crystalline SiC is prepared such that its main surface is in the direction at which the minimum angle between the main surface and a plane perpendicular to the (0001) plane is one degree or less, for example, in the direction at which the minimum angle between the main surface and the [0001] direction, which is perpendicular to the (0001) plane, is one degree or less. A horizontal semiconductor device is formed on one main surface of the substrate prepared by the foregoing method. Thus, it was possible to improve the value of breakdown voltage significantly over the horizontal semiconductor device in which the main surface of the substrate composed of hexagonally crystalline SiC is in the direction along the (0001) direction.

## Description

### Technical Field

The present invention relates to a semiconductor device and a method of producing a semiconductor device, more specifically both to a semiconductor device that is a horizontal type and that has a value of breakdown voltage and on-resistance both improved by controlling the direction of the crystal plane of the substrate and to a method of producing the semiconductor device.

### Background Art

In recent years, apparatuses incorporating semiconductor devices have enhanced their performance. Accordingly, the market has been increasingly demanding the semiconductor devices to increase their operation rate and decrease their loss. To meet the requirement, it is important to increase the breakdown voltage and decrease the on-resistance of the semiconductor devices.

Generally, for example, in the case of a vertical semiconductor device such as a metal oxide semiconductor (MOS) diode formed by using a substrate composed of hexagonally crystalline silicon carbide (SiC), when a polycrystalline-type 4H-SiC substrate is formed, for example, so as to be in the direction along the (0001) plane, at the time of driving, an electric field is generated in the direction along the [0001] direction, which is a direction perpendicular to the substrate. However, for example, in the case of a horizontal semiconductor device such as a metal oxide semiconductor field effect transistor (MOSFET) and a junction field effect transistor (JFET), when the SiC substrate is formed, for example, so as to be in the direction along the (0001) plane of the 4H-SiC, the following property can be recognized. That is, for example, as in the horizontal semiconductor device stated in the below-described Nonpatent literature 1, an electric field is generated in the direction intersecting the [0001] direction, which is the direction along the (0001) plane.
Nonpatent literature 1: Masato Noborio and three others, "Materials Science Forum," 2006, Vols. 527-529, pp. 1305-1308.

### Disclosure of the Invention

### Problem to be Solved by the Invention

Generally, it is known that the insulation breakdown electric field in the direction along the (0001) plane is lower than that in the direction intersecting the (0001) plane. More specifically, the insulation breakdown electric field is about 3/4 of that in the direction intersecting the direction of the (0001) plane. Consequently, the breakdown voltage between the electrodes formed in the direction along the (0001) plane is as small as about 0.6 times the breakdown voltage between the electrodes formed in the direction intersecting the (0001) plane in the case where the substrate is prepared so as to be in the direction intersecting the (0001) plane. In other words, the value of the generated electric field has an anisotropy with respect to the crystal plane of the substrate, which is a known phenomenon.

According to the above description, for example, as stated in Nonpatent literature 1, when a horizontal semiconductor device is prepared such that the main surface of the 4H-SiC substrate is in the direction along the (0001) plane, the values of the insulation breakdown electric field and breakdown voltage of the horizontal semiconductor device are lower than those of the vertical semiconductor device.

In addition, the same can be applied to the electron mobility. In the drift layer, which is a main component forming the resistance of a vertical semiconductor device that is prepared such that the main surface of the 4H-SiC substrate is in the direction along the (0001) plane, the electric current flows in the direction perpendicular to the (0001) plane of the 4H-SiC substrate. However, for example, in the case of a horizontal semiconductor device formed such that the main surface of the 4H-SiC substrate is in the direction along the (0001) plane, the electric current flows in the direction along the (0001) plane. As with the fact that the insulation breakdown electric field in the direction along the (0001) plane is lower than that in the direction intersecting the (0001) plane, the electron mobility in the direction along the (0001) plane is about 0.8 times that in the direction intersecting the (0001) plane, which is already known. Consequently, for example, when the main surface of the 4H-SiC substrate is prepared so as to be in the direction along the (0001) plane, the value of the electron mobility is lower than that when, for example, the main surface of the 4H-SiC substrate is prepared so as to be in the direction intersecting the (0001) plane. Accordingly, the value of the current becomes also lower, which is a problem. According to the above description, a problem such as described below can be created. For example, when the main surface of the 4H-SiC substrate is prepared so as to be in the direction along the (0001) plane, the value of the electric current of the semiconductor device becomes lower than the theoretical value of the material forming the substrate (in this case, SiC). As a result, the on-resistance is increased.

In view of the above circumstances, the present invention is made to solve the above-described problem. An object of the present invention is to offer both a semiconductor device that is a horizontal type and that has a value of breakdown voltage and on-resistance both improved by controlling the direction of the crystal plane of the substrate and a method of producing the foregoing semiconductor device. Means to Solve the Problem

A semiconductor device of the present invention is provided with the following members:
(a) a substrate that is composed of hexagonally crystalline silicon carbide and that has a main surface forming a minimum angle of one degree or less with respect to a plane perpendicular to the (0001) plane,
(b) a semiconductor layer placed on one main surface of the substrate,
(c) a source region formed in one surface layer of the semiconductor layer, and
(d) a drain region formed in the surface layer of the semiconductor layer so as to be separated from the source region with some distance.
   The specifying of the crystal plane at which the substrate is prepared as described above enables the offering of a horizontal semiconductor device that has improved values of breakdown voltage and on-resistance.

In the semiconductor device of the present invention, the main surface of the substrate has a crystal plane whose angle of intersection with the (0001) plane, that is, the angle forming with the (0001) plane, is close to the right angle. For example, it is conceivable that the minimum angle between the main surface of the substrate and a plane equivalent to the (11-20) plane is one degree or less. Alternatively, it is conceivable that the minimum angle between the main surface of the substrate and a plane equivalent to the (1-100) plane is one degree or less.

The semiconductor device of the present invention has a structure that is further provided with a gate region in the surface layer existing between the source region and the drain region both on the one main surface of the semiconductor layer. Alternatively, the semiconductor device of the present invention has a structure that is further provided with the following members:
(a) a gate-insulating film in the surface layer existing between the source region and the drain region both on the one main surface of the semiconductor layer, and
(b) a gate electrode on one main surface of the gate-insulating film.
   Yet alternatively, the semiconductor device of the present invention has a structure that is further provided with a gate electrode on the surface layer existing between the source region and the drain region both on the one main surface of the semiconductor layer, the gate electrode being in Schottky contact with the semiconductor layer.

The method of the present invention for producing the semiconductor device is provided with the following steps:
(a) preparing a substrate that is composed of hexagonally crystalline silicon carbide and that has a main surface forming a minimum angle of one degree or less with respect to a plane perpendicular to the (0001) plane,
(b) forming a semiconductor layer placed on one main surface of the substrate, and
(c) forming a source region formed in one surface layer of the semiconductor layer and a drain region formed in the surface layer of the semiconductor layer so as to be separated from the source region with some distance.
   The performing of the step that specifies the crystal plane for preparing the substrate as described above enables the offering of a horizontal semiconductor device that has improved values of breakdown voltage and on-resistance.

In the semiconductor device formed through the above-described production method, also, for example, it is conceivable that the minimum angle between the main surface of the substrate and a plane equivalent to the (11-20) plane is one degree or less. Alternatively, it is conceivable that the minimum angle between the main surface of the substrate and a plane equivalent to the (1-100) plane is one degree or less.

The method of the present invention for producing a semiconductor device is further provided with a step of forming a gate region in the surface layer existing between the source region and the drain region both on the one main surface of the semiconductor layer. Alternatively, the method of the present invention for producing a semiconductor device is further provided with the following steps:
(a) forming a gate-insulating film in the surface layer existing between the source region and the drain region both on the one main surface of the semiconductor layer, and
(b) forming a gate electrode on one main surface of the gate-insulating film.
   Yet alternatively, the method of the present invention for producing a semiconductor device is further provided with a step of forming a gate electrode on the surface layer existing between the source region and the drain region both on the one main surface of the semiconductor layer, the gate electrode being to be in Schottky contact with the semiconductor layer.

### Effect of the Invention

The present invention can offer a horizontal semiconductor device that has an improved breakdown voltage and on-resistance, because the device incorporates an SiC substrate whose main surface forms a minimum angle of one degree or less with respect to a plane perpendicular to the (0001) plane.

### Brief Description of the Drawing

Figure 1 is a flowchart showing the method of producing the semiconductor device in Embodiment 1 of the present invention.
Figure 2 is a schematic diagram showing the state after performing a step (S10) and a step (S20) both shown in the flowchart in Fig. 1 in Embodiment 1 of the present invention.
Figure 3 is a schematic diagram showing the state after performing a step (S30) shown in the flowchart in Fig. 1 in Embodiment 1 of the present invention.
Figure 4 is a schematic diagram showing the state after performing a step (S40) shown in the flowchart in Fig. 1 in Embodiment 1 of the present invention.
Figure 5 is a schematic diagram showing the state after performing a step (S60) shown in the flowchart in Fig. 1 in Embodiment 1 of the present invention.
Figure 6 is a schematic diagram showing the state after performing a step (S70) shown in the flowchart in Fig. 1 in Embodiment 1 of the present invention.
Figure 7 is a flowchart showing the method of producing the semiconductor device in Embodiment 2 of the present invention.
Figure 8 is a schematic diagram showing the state after performing a step (S80) shown in the flowchart in Fig. 7 in Embodiment 2 of the present invention.
Figure 9 is a flowchart showing the method of producing the semiconductor device in Embodiment 3 of the present invention.
Figure 10 is a schematic diagram showing the state after performing a step (S60) shown in the flowchart in Fig. 9 in Embodiment 3 of the present invention.
Figure 11 is a schematic diagram showing the state after performing a step (S80) shown in the flowchart in Fig. 9 in Embodiment 3 of the present invention.
Figure 12 is a schematic diagram, for Embodiment 4 of the present invention, showing the state after performing a step (S10) and a step (S20) shown in the flowchart in Fig. 1.
Figure 13 is a schematic diagram, for Embodiment 4 of the present invention, showing the state after performing a step (S30) shown in the flowchart in Fig. 1.
Figure 14 is a schematic diagram, for Embodiment 4 of the present invention, showing the state after performing a step (S40) shown in the flowchart in Fig. 1.
Figure 15 is a schematic diagram, for Embodiment 4 of the present invention, showing the state after performing a step (S60) shown in the flowchart in Fig. 1.
Figure 16 is a schematic diagram, for Embodiment 1 of the present invention, showing the state after performing a step (S70) shown in the flowchart in Fig. 1.

### Best Mode for Carrying Out the Invention

Embodiments of the present invention are explained below by referring to the drawing. In the individual embodiments, the same reference sign is given to the member exercising the same function to eliminate a duplicated explanation for that member unless particularly required.

### EMBODIMENT 1

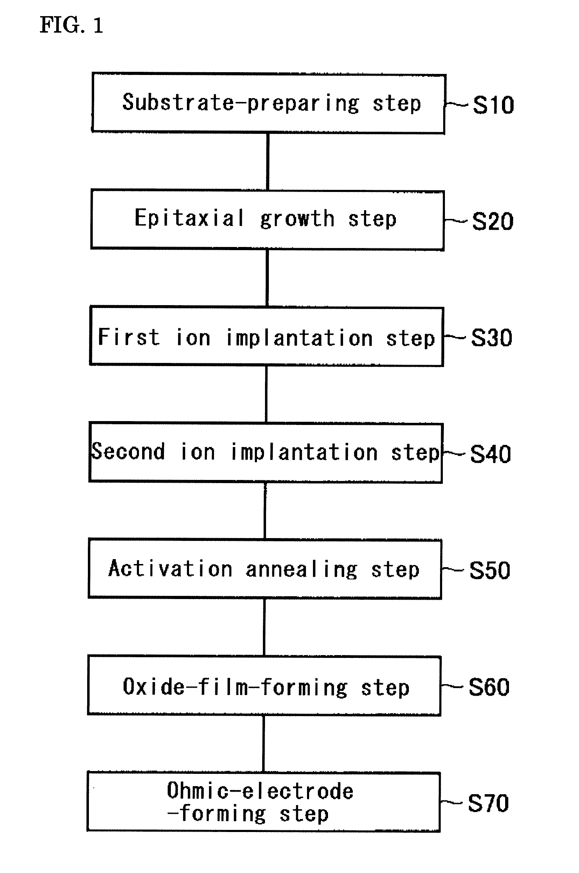

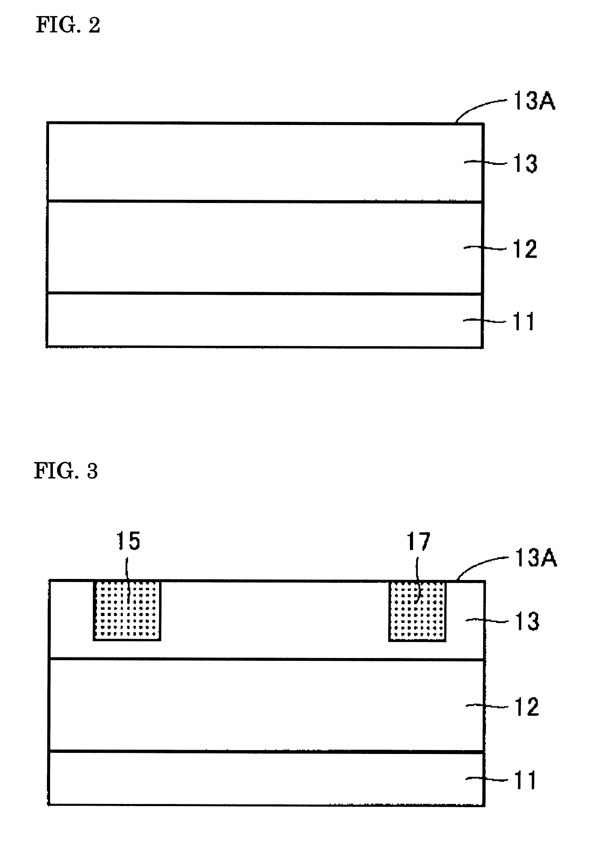

Figure 1 is a flowchart showing the method of producing the semiconductor device in Embodiment 1 of the present invention. Figure 2 is a schematic diagram showing the state after performing a step (S10) and a step (S20) both shown in the flowchart in Fig. 1 in Embodiment 1 of the present invention.

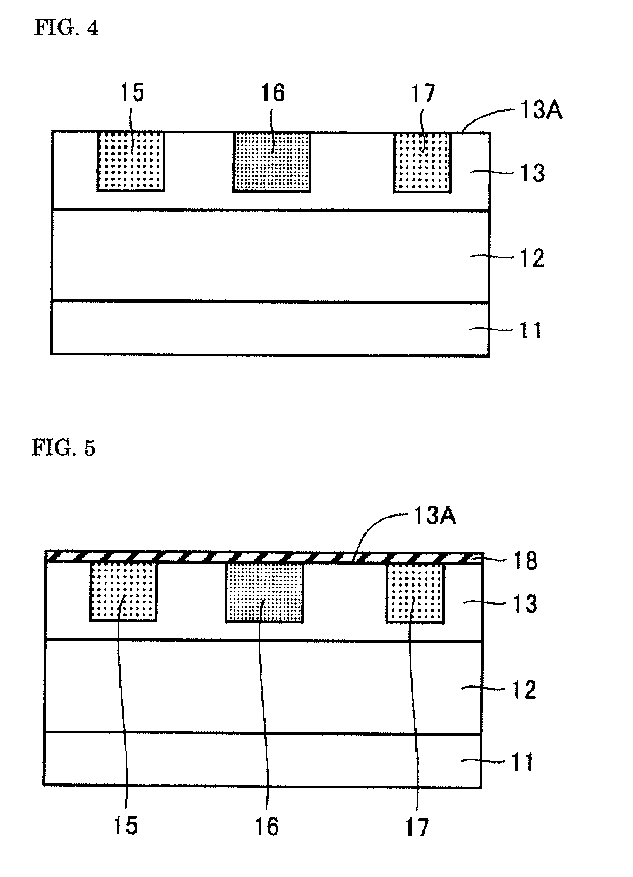

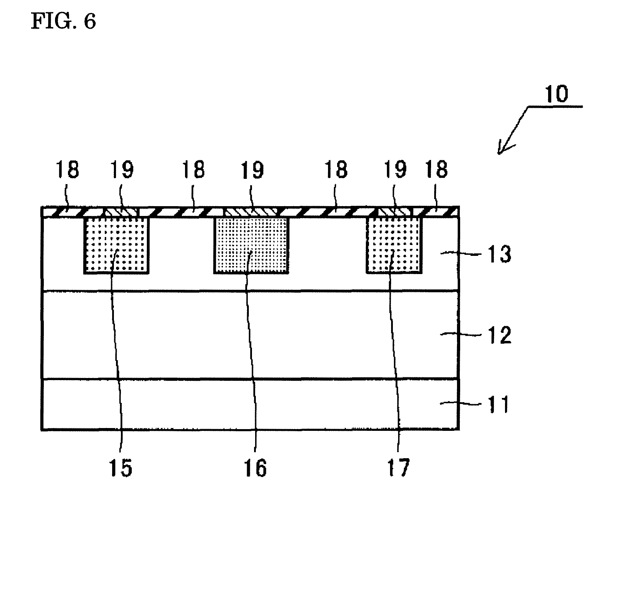

Figure 3 is a schematic diagram showing the state after performing a step (S30) shown in the flowchart in Fig. 1 in Embodiment 1 of the present invention. Figure 4 is a schematic diagram showing the state after performing a step (S40) shown in the flowchart in Fig. 1 in Embodiment 1 of the present invention. Figure 5 is a schematic diagram showing the state after performing a step (S60) shown in the flowchart in Fig. 1 in Embodiment 1 of the present invention. Figure 6 is a schematic diagram showing the state after performing a step (S70) shown in the flowchart in Fig. 1 in Embodiment 1 of the present invention.

Embodiment 1 of the present invention shows the method of producing a horizontal JFET 10 shown in Fig. 6 among semiconductor devices. As shown in Fig. 6, the horizontal JFET 10 is a semiconductor device that is provided with an n-type substrate 11, which has an n-type conduction type; a p-type semiconductor layer 12 formed on one main surface of the n-type substrate 11; an n-type semiconductor layer 13 formed on the p-type semiconductor layer 12; a source region 15 to which electrons are supplied; a drain region 17 from which electrons are taken out; and a gate region 16, which is placed between the source region 15 and the drain region 17 and which electrically connects or disconnects between the source region 15 and the drain region 17. The semiconductor device is composed of, for example, SiC forming a hexagonal crystal. It is desirable that the SiC be a polycrystalline type known as 4H-SiC.

The n-type substrate 11, which constitutes a part of the JFET 10 in Embodiment 1 of the present invention, which is composed of SiC, and which has an n-type conduction type, is prepared so as to be in the direction at which the minimum angle between its main surface and a plane perpendicular to the (0001) plane is one degree or less, for example, in the direction at which the minimum angle between the main surface and the [0001] direction, which is perpendicular to the (0001) plane, is one degree or less. The types of the crystal plane having a main surface in the direction along the [0001] direction include, for example, a plane equivalent to the (11-20) plane and a plane equivalent to the (1-100) plane. Consequently, it is desirable to prepare the n-type substrate 11 so as to form a minimum angle of one degree or less with respect to, for example, a plane equivalent to the (11-20) plane. Alternatively, it is desirable to prepare the n-type substrate 11 so as to from a minimum angle of one degree or less with respect to a plane equivalent to the (1-100) plane.

The p-type semiconductor layer 12 is formed on the one main surface of the n-type substrate 11 by epitaxial growth. The n-type semiconductor layer 13 is formed on the p-type semiconductor layer 12 by the same method of epitaxial growth. The reason for performing the epitaxial growth is to minimize the floating capacitance of the semiconductor device. As shown in Fig. 6, the source region 15 and the drain region 17 are formed separately with some distance in a region within a certain depth from the one main surface of the n-type semiconductor layer 13, that is, in a surface layer. The gate region 16 is formed in the surface layer existing between the source region 15 and the drain region 17. The source region 15 and the drain region 17 are regions containing a dopant that has an n-type conduction type (an n-type dopant) and that has a concentration higher than that in the n-type semiconductor layer 13. The gate region 16 is a region containing a dopant that has a p-type conduction type (a p-type dopant) and that has a concentration higher than that in the p-type semiconductor layer 12. The JFET 10 may have a configuration inverted from the above-described configuration with respect to the conduction type (a p-type and n-type) of the semiconductor. In other words, the JFET 10 may have a structure in which an n-type semiconductor layer and a p-type semiconductor layer are successively formed on one main surface of a p-type substrate that is composed of p-type SiC and that has a p-type conduction type.

An ohmic electrode 19 is formed so as to be in contact with the top surface of each of the source region 15, the gate region 16, and the drain region 17. The ohmic electrode 19 is formed of material that can achieve ohmic contact with the source region 15, the gate region 16, and the drain region 17, such as nickel silicide (NiSi).

An oxide film 18 is formed between the neighboring ohmic electrodes 19. More specifically, the oxide films 18 as insulating layers are formed on the top surface of the n-type semiconductor layer 13 so as to cover the entire region other than the regions in which the ohmic electrodes 19 are formed. Thus, the neighboring ohmic electrodes 19 are insulated from each other.

Next, an explanation is given to the method of producing the semiconductor device in Embodiment 1 of the present invention by referring to Figs. 1 to 6. In the method of producing the JFET 10, which is the semiconductor device in Embodiment 1 of the present invention, first, as shown in Fig. 1, a substrate-preparing step (S10) is performed. More specifically, as described above, the n-type substrate 11 (see Figs. 2 to 6), which has an n-type conduction type and which is composed of SiC whose crystal is a hexagonal crystal, is prepared so as to be in the direction at which the minimum angle between its main surface and a plane perpendicular to the (0001) plane is one degree or less, for example, in the direction at which the minimum angle between the main surface and, for example, the [0001] direction, which is perpendicular to the (0001) plane, is one degree or less. The types of the crystal plane having a main surface in the direction along the [0001] direction include, for example, a plane equivalent to the (11-20) plane and a plane equivalent to the (1-100) plane. Consequently, it is desirable to prepare the n-type substrate 11 so as to form a minimum angle of one degree or less with respect to, for example, a plane equivalent to the (11-20) plane. Alternatively, it is desirable to prepare the n-type substrate 11 so as to form a minimum angle of one degree or less with respect to a plane equivalent to the (1-100) plane.

Next, as shown in Fig. 1, an epitaxial growth step (S20) is performed. More specifically, as shown in Fig. 2, in this step, the p-type semiconductor layer 12 and the n-type semiconductor layer 13 both composed of SiC are successively formed in lamination through, for example, vapor phase epitaxial growth on one main surface of the n-type substrate 11 prepared in the previous step (S10). Electric current flows in the n-type semiconductor layer 13. To control the path of the current (to suppress the width of the current path from excessively broadening), the p-type semiconductor layer 12 is placed. In the vapor phase epitaxial growth, for example, a silane (SiH₄) gas and a propane (C₃H₈) gas may be used as the material gas and a hydrogen (H₂) gas may be used as the carrier gas. As the p-type dopant source for forming the p-type semiconductor layer 12, for example, diborane (B₂H₆) or trimethylaluminum (TMA) may be used. As the n-type dopant source for forming the n-type semiconductor layer 13, for example, a nitrogen (N₂) gas may be used.

Next, as shown in Fig. 1, a first ion implantation step (S30) is performed. More specifically, in this step, the source region and the drain region both containing a high-concentration n-type dopant are formed. By referring to Fig. 3, first, photoresist is applied onto a top surface 13A of the n-type semiconductor layer 13. Then, exposure to light and development are performed to form a resist film having openings at areas according to the shape of the source region 15 and drain region 17. By using the resist film as a mask, an n-type dopant, such as phosphorus (P), is introduced into the n-type semiconductor layer 13 through the ion implantation. In place of P, nitrogen (N) may be ion-implanted. Furthermore, in place of the ion implantation, an n-type epitaxial layer may be grown as a buried layer to perform a step as the first ion implantation step (S30). Thus, the source region 15 and the drain region 17 are formed.

Next, a second ion implantation step (S40) is performed. In this step (S40), the gate region containing a high-concentration p-type dopant is formed. More specifically, by referring to Fig. 4, first, as with the procedure used in the step (S30), a resist film is formed that has an opening at an area according to the shape of the gate region 16. By using the resist film as a mask, a p-type dopant, such as aluminum (Al), is introduced into the n-type semiconductor layer 13 through ion implantation. In place of Al, boron (B) may be ion-implanted. Furthermore, in place of the ion implantation, a p-type epitaxial layer may be grown as a buried layer to perform a step as the second ion implantation step (S40). Thus, the gate region 16 is formed. The present invention does not strictly specify the order of performing the above-described first ion implantation step (S30) and second ion implantation step (S40). In other words, the two steps may be performed with the reversed order.

Next, an activation annealing step (S50) is performed. In this step (S50), first, the resist film formed in the step (S40) is removed. Then, the n-type semiconductor layer 13, which has undergone the ion implantation in the steps (S30) and (S40), is heated to activate the dopants introduced by the above-described ion implantation. Thus, activation annealing is performed by conducting a heat treatment. The activation annealing may be performed by conducting the heat treatment in, for example, an argon (Ar) gas atmosphere. The activation annealing may also be performed by conducting the heat treatment in an inert-gas atmosphere, such as a neon (Ne) gas atmosphere, in place of the Ar gas atmosphere. Furthermore, the activation annealing may also be performed by conducting the heat treatment in a vacuum.

Next, an oxide-film-forming step (S60) is performed. By referring to Fig. 5, this step (S60) performs the heat oxidation of the n-type semiconductor layer 13, which includes the ion-implanted layers formed through the steps (S10) to (S50), the p-type semiconductor layer 12, and the n-type substrate 11. Thus, an oxide film 18 composed of silicon dioxide (SiO₂) is formed as a field oxide film so as to cover the top surface 13A of the n-type semiconductor layer 13.

Next, an ohmic-electrode-forming step (S70) is performed. As shown in Fig. 6, in this step (S70), an ohmic electrode 19 composed of, for example, NiSi is formed so as to be in contact with the top surface of each of the source region 15, the gate region 16, and the drain region 17. More specifically, first, by the same procedure as used in the step (S30), a resist film is formed that has openings at areas according to the shapes of the ohmic electrodes 19. By using the resist film as a mask, the oxide film 18 (the field oxide film) on the source region 15, the gate region 16, and the drain region 17 is removed by, for example, reactive ion etching (RIE).

Subsequently, by vapor-depositing, for example, Ni, an Ni layer is formed on the source region 15, the gate region 16, and the drain region 17, all of which are exposed at the openings of the oxide film 18 before the Ni layer is formed, and on the resist film as well. Then, by removing the resist film, the Ni layer on the resist film is removed (the liftoff method). As a result, the Ni layer remains on the source region 15, the gate region 16, and the drain region 17, all of which were exposed at the openings of the oxide film 18 before the Ni layer was formed. Next, heat treatment is performed by heating them at about 950°C for about two minutes in, for example, an argon (Ar) atmosphere. The heat treatment performs silicidation of the Ni layer. Thus, as shown in Fig. 6, the ohmic electrodes 19 are formed that are composed of NiSi and that can form ohmic contact with the source region 15, the gate region 16, and the drain region 17.

In addition to the above-described liftoff method, the ohmic electrode can be formed by another method, which etching-removes unnecessary portions in the film through the photolithographic technique after the film is formed on the entire surface. More specifically, as in the above-described ohmic-electrode-forming step (S70), first, the oxide film 18 (the field oxide film) on the source region 15, the gate region 16, and the drain region 17 is removed. Then, by vapor-depositing, for example, Ni, an Ni layer is formed. Subsequently, photoresist is applied onto the top surface of the formed Ni layer. Next, exposure to light and development are performed to form a resist film having openings at areas other than the areas for the source region 15, gate region 16, and drain region 17. By using the resist film as a mask, the Ni layer is removed at the areas where no Ni layer is required (the areas other than the areas on the source region 15, the gate region 16, and the drain region 17) through, for example, wet etching. As a result, the Ni layer remains on the source region 15, gate region 16, and drain region 17. After that, as with the above-described procedure, heat treatment is performed by heating them at about 950°C for about two minutes in, for example, an Ar atmosphere. The heat treatment performs silicidation of the Ni layer. Thus, as shown in Fig. 6, the ohmic electrodes 19 are formed that are composed of NiSi and that can form ohmic contact with the source region 15, the gate region 16, and the drain region 17.

In Embodiment 1 of the present invention, as described above, the JFET 10 may have a configuration inverted from the above-described configuration with respect to the conduction type (a p-type and n-type) of the semiconductor. In the case where the inverted configuration is employed, when the ohmic electrodes 19 are to be formed on the top surface of the p-type semiconductor layer 12, the ohmic electrodes may be formed by using alloy composed of titanium (Ti) and Al, which is TiAl. More specifically, a Ti layer and an Al layer are successively formed on the source region 15, the gate region 16, and the drain region 17 using, for example, the above-described liftoff method or photolithographic technique. After that, as with the above-described procedure, heat treatment is performed by heating them at about 950°C for about two minutes in, for example, an Ar atmosphere. The heat treatment forms the ohmic electrodes 19 that are composed of TiAl and that can form ohmic contact with the source region 15, the gate region 16, and the drain region 17.

The JFET 10 formed through the above-described steps uses a depletion layer formed in the reverse-biased p-n junction to vary the cross-sectional area of the region through which the electric current flows. Thus, the current flowing between the source region 15 and the drain region 17 is controlled. In other words, this structure directs the current to flow between the source region 15 and the drain region 17, that is, to flow in the direction along the main surface of the n-type substrate 11. Therefore, this structure has a horizontal structure. Consequently, as shown in Embodiment 1 of the present invention, the n-type substrate 11 is prepared so as to be in the direction at which the minimum angle between its main surface and a plane perpendicular to the (0001) plane is one degree or less, for example, in the direction at which the minimum angle between the main surface and, for example, the [0001] direction, which is perpendicular to the (0001) plane, is one degree or less. As a result, in comparison with, for example, the case where the preparation is performed in such a way that the main surface is in the direction along the (0001) plane, the values of the insulation breakdown electric field, breakdown voltage, and electron mobility can be increased and the value of the on-resistance can be decreased.

### EMBODIMENT 2

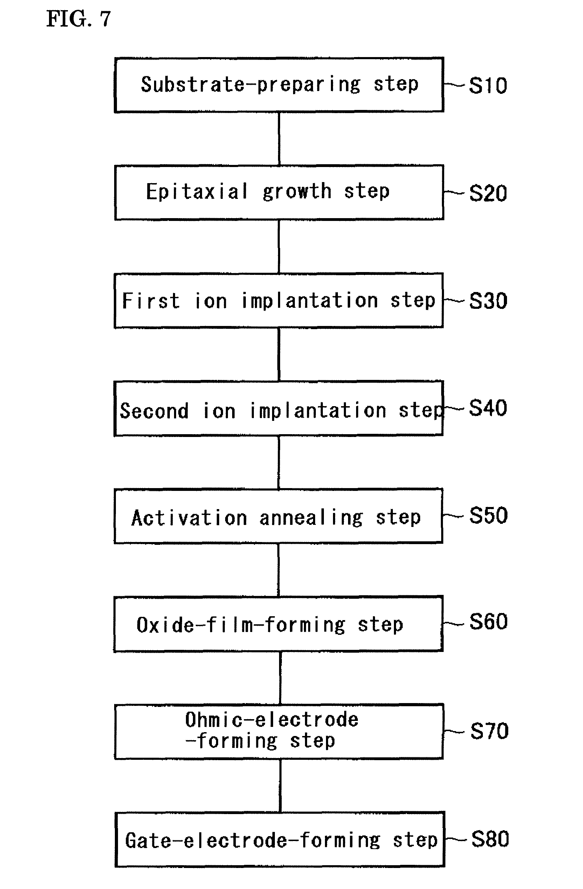

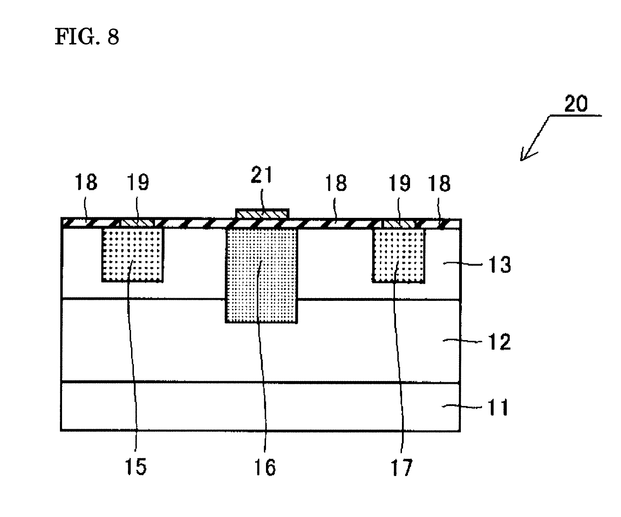

Figure 7 is a flowchart showing the method of producing the semiconductor device in Embodiment 2 of the present invention. Figure 8 is a schematic diagram showing the state after performing a step (S80) shown in the flowchart in Fig. 7 in Embodiment 2 of the present invention.

Embodiment 2 of the present invention shows the method of producing a horizontal MOSFET 20 shown in Fig. 8 among semiconductor devices. As shown in Fig. 8, in the horizontal MOSFET 20, an ohmic electrode 19 is formed so as to be in contact with the top surface of each of the source region 15 and the drain region 17. In the top surface 13A of the n-type semiconductor layer 13 (see Figs. 2 to 5), an oxide film 18 is formed on the top surface of the gate region 16 as with the areas other than the areas on the top surface of the source region 15 and the drain region 17. Of the oxide films 18, in particular, the oxide film 18 formed on the top surface of the gate region 16 is used as a gate oxide film. A gate electrode 21 is formed on the top surface of that oxide film 18 (the gate oxide film). The horizontal MOSFET 20 is different from the horizontal JFET 10 in Embodiment 1 of the present invention only in the above-described features.

As shown in Figs. 7 and 8, the method of producing the horizontal MOSFET 20 in Embodiment 2 of the present invention is the same as that of the horizontal JFET 10 in Embodiment 1 of the present invention in the steps from the substrate-preparing step (S10) to the activation annealing step (S50). Nevertheless, as shown in Fig. 8, in the second ion implantation step (S40), the gate region 16 is formed so as to pass through the n-type semiconductor layer 13 and penetrate into the p-type semiconductor layer 12 to a certain depth. This structure interconnects the gate region 16 with the p-type semiconductor layer 12. As a result, the operation of the MOSFET 20 by the inversion of the gate region 16 can be performed smoothly. In this case, it is desirable that the concentration of the p-type dopant to be implanted into the gate region 16 be comparable to that of the p-type dopant contained in the p-type semiconductor layer 12 and be adjusted so as to fall within an error range of 10%.

In the next oxide-film-forming step (S60), the oxide film 18 is formed at the gate region 16's top surface in the n-type semiconductor layer 13's top surface 13A (see Figs. 2 to 5). The oxide film 18 is an oxide film for creating the field effect of the MOS structure. Consequently, in comparison with the previously described oxide film 18 (the field oxide film) formed in the oxide-film-forming step (S60) in Embodiment 1 of the present invention, the oxide film 18 (the gate oxide film) having a desired thickness can be formed by performing a heat oxidation for a shorter time. In this case, the thickness of the oxide films 18 formed in the area other than both the area at which the gate oxide film, which is the oxide film 18 on the gate region 16, is formed and the area at which ohmic electrodes are to be formed in the next step (S70) is thinner than the thickness of, for example, the previously described oxide film 18 (the field oxide film) formed in Embodiment 1 of the present invention. After the formation of the above-described oxide film 18 (the gate oxide film), in the top surface 13A of the n-type semiconductor layer 13, the formation of the oxide film may be further continued only in the area other than both the area at which the gate oxide film is formed and the area at which ohmic electrodes are to be formed in the next step (S70), for example. When this operation is implemented, a field oxide film thicker than the gate oxide film can be formed.

Next, the ohmic-electrode-forming step (S70) is performed. More specifically, as shown in Fig. 8, an ohmic electrode 19 composed of, for example, NiSi is formed so as to be in contact with the top surface of each of the source region 15 and the drain region 17. In the case where the inverted configuration is employed as described earlier, when the ohmic electrodes 19 are to be formed on the top surface of the p-type semiconductor layer, the ohmic electrodes may be formed by using alloy composed of titanium (Ti) and Al, which is TiAl.

Next, a gate-electrode-forming step (S80) is performed. More specifically, as shown in Fig. 8, a gate electrode 21 formed of, for example, an Al layer is formed so as to be in contact with the top surface of the oxide film 18 (the gate oxide film) formed, in the above-described oxide-film-forming step (S60), on the top surface of the gate region 16. More specifically, for example, after the ohmic-electrode-forming step (S70) is performed, for example, Al is vapor-deposited on the entire top surface of both the oxide films 18 and the ohmic electrodes 19 to form an Al layer. Subsequently, photoresist is applied onto the top surface of the formed Al layer. Then, exposure to light and development are performed to form a resist film having openings at areas other than the area on the top surface of the oxide film 18 (the gate oxide film) formed on the top surface of the gate region 16. By using the resist film as a mask, the Al layer is removed at the areas where no Al layer is required (the areas other than the area on the top surface of the oxide film 18 (the gate oxide film) formed on the top surface of the gate region 16) through, for example, wet etching. As a result, the Al layer remains on the top surface of the oxide film 18 (the gate oxide film) formed on the top surface of the gate region 16. The above-described operation forms the Al layer as the gate electrode 21 at the desired location.

In place of the above-described Al, the gate electrode 21 may be formed by using polycrystalline silicon. In this case, the gate electrode is formed through the same method as used in the case of the above-described Al. In addition to the above-described method, the gate electrode 21 may be formed by using, for example, the liftoff method.

In the MOSFET 20 formed through the above-described steps, a channel layer is formed in the surface layer existing between the source region 15 and the drain region 17 in the n-type semiconductor layer 13. The MOSFET 20 controls the value of the current flowing between the source region 15 and the drain region 17 by changing the state of the channel layer in the surface layer (especially in the vicinity of the gate region 16) according to the magnitude of the voltage applied to the gate electrode 21. In other words, this structure directs the current to flow between the source region 15 and the drain region 17, that is, to flow in the direction along the main surface of the n-type substrate 11. Therefore, this structure has a horizontal structure. Consequently, as shown in Embodiment 2 of the present invention, the n-type substrate 11 is prepared so as to be in the direction at which the minimum angle between its main surface and a plane perpendicular to the (0001) plane is one degree or less, for example, in the direction at which the minimum angle between the main surface and the [0001] direction, which is perpendicular to the (0001) plane, is one degree or less. As a result, in comparison with, for example, the case where the preparation is performed in such a way that the main surface is in the direction along the (0001) plane, the values of the insulation breakdown electric field, breakdown voltage, and electron mobility can be increased and the value of the on-resistance can be decreased, as described before.

Embodiment 2 is different from Embodiment 1 of the present invention only in the above-described features. More specifically, the structure, conditions, production steps, and so on all not described in the explanation of Embodiment 2 of the present invention are in conformance with those of Embodiment 1 of the present invention.

### EMBODIMENT 3

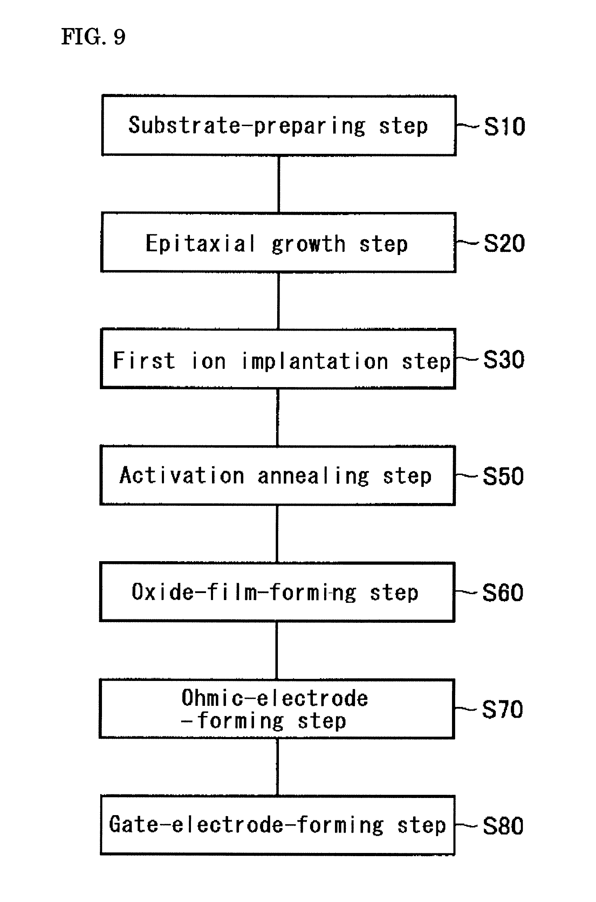

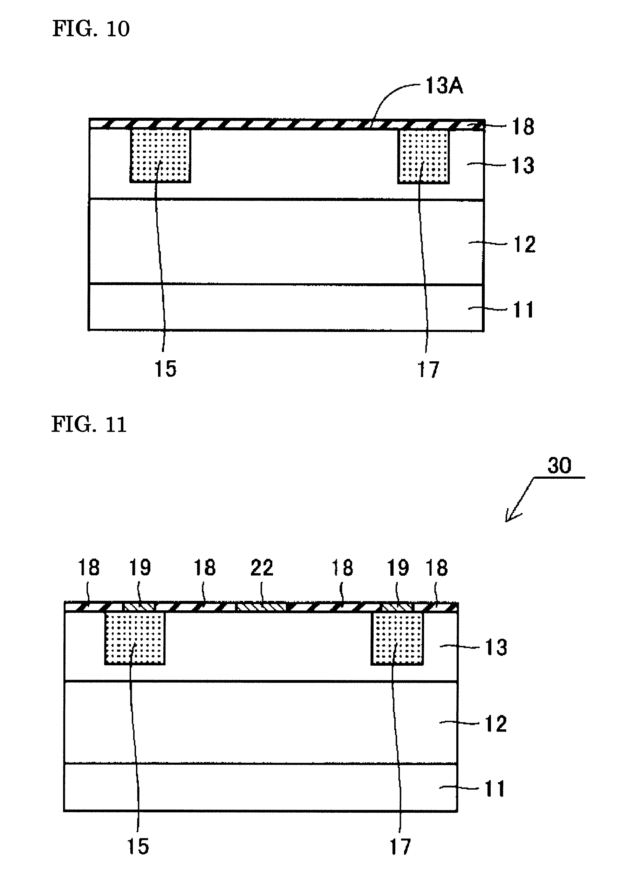

Figure 9 is a flowchart showing the method of producing the semiconductor device in Embodiment 3 of the present invention. Figure 10 is a schematic diagram showing the state after performing the step (S60) shown in the flowchart in Fig. 9 in Embodiment 3 of the present invention. Figure 11 is a schematic diagram showing the state after performing the step (S80) shown in the flowchart in Fig. 9 in Embodiment 3 of the present invention.

Embodiment 3 of the present invention shows the method of producing a horizontal MESFET 30 shown in Fig. 11 among semiconductor devices. As shown in Fig. 11, in the horizontal MESFET 30, an ohmic electrode 19 is formed so as to be in contact with the top surface of each of the source region 15 and the drain region 17. The gate region 16 provided in, for example, the JFET 10 shown in Fig. 6 and the MOSFET 20 shown in Fig. 8 is not provided in the MESFET 30. Instead, a gate electrode 22 that is in Schottky contact with the n-type semiconductor layer 13 is directly placed on the top surface 13A of the n-type semiconductor layer 13. More specifically, the gate electrode 22 is placed on the top surface of the region where the gate region 16 is provided in the JFET 10 and the MOSFET 20. The horizontal MESFET 30 is different from the horizontal JFET 10 in Embodiment 1 of the present invention only in the above-described feature.

As shown in Figs. 7 and 8, the method of producing the horizontal MESFET 30 in Embodiment 3 of the present invention is the same as that of the horizontal JFET 10 in Embodiment 1 of the present invention in the steps from the substrate-preparing step (S10) to the first ion implantation step (S30). Nevertheless, as described above, because the gate region 16 is not formed, the second ion implantation is not performed. Therefore, the next step is the activation annealing step (S50). The activation annealing step (S50) and the oxide-film-forming step (S60) are the same as those of the previously described horizontal JFET 10 in Embodiment 1 of the present invention.

Next, the ohmic-electrode-forming step (S70) is performed. More specifically, as shown in Fig. 11, an ohmic electrode 19 composed of, for example, NiSi is formed so as to be in contact with the top surface of each of the source region 15 and the drain region 17. In the case where the inverted configuration is employed as described earlier, when the ohmic electrodes 19 are to be formed on the top surface of the p-type semiconductor layer, the ohmic electrodes may be formed by using alloy composed of titanium (Ti) and Al, which is TiAl.

Next, the gate-electrode-forming step (S80) is performed. More specifically, in this step, for example, the gate electrode 22 is formed on the n-type semiconductor layer 13's surface existing between the source region 15 and the drain region 17 (in the top surface 13A of the n-type semiconductor layer 13, the top surface of the region where the gate region 16 is provided in the JFET 10 and the MOSFET 20). More specifically, for example, after the ohmic-electrode-forming step (S70) is performed, photoresist is applied onto the entire top surface of the oxide films 18 and the ohmic electrodes 19. Then, exposure to light and development are performed to form a resist film having an opening at the area according to the shape of the oxide film 18 at the area where the gate electrode 22 is to be formed. In other words, in the top surface 13A of the n-type semiconductor layer 13, the opening is located at the top surface of the region where the gate region 16 is provided in the JFET 10 and the MOSFET 20. By using the resist film as a mask, a metallic material that can be in Schottky contact with the n-type semiconductor layer 13, such as Ni, is vapor-deposited. Thus, an Ni layer is formed on the top surface of the exposed n-type semiconductor layer 13 without being covered by the oxide film 18 (the exposed portion is the area where the gate electrode 22 is to be formed) and on the resist film on the top surface of the oxide films 18 and the ohmic electrodes 19. Then, by removing the resist film, the Ni layer on the resist film is removed (the liftoff method). As a result, the Ni layer remains on the once exposed n-type semiconductor layer 13 without being covered by the oxide film 18. Thus, the Ni layer as the gate electrode 22 is formed at the desired location.

In the case where the inverted configuration is employed as described earlier, when the gate electrode 22 is to be formed on the top surface of the p-type semiconductor layer, the gate electrode 22 may be formed by using Ti in place of the above-described Ni and by using the same method as used in the case of the above-described Ni. In addition to the above-described method, the gate electrode 22 may be formed by using an any method that properly combines, for example, the above-described liftoff method and the photolithographic technique.

The MESFET 30 formed through the above-described steps differs from the earlier-described JFET 10 in that, for example, in place of the p-n junction used in the gate region of the JFET 10, a Schottky contact between a metal and a semiconductor (between the gate electrode 22 and the n-type semiconductor layer 13) is used. Nevertheless, the MESFET 30 performs the operation basically similar to that of the JFET 10. More specifically, the MESFET 30 controls the current flowing between the source region 15 and the drain region 17. In other words, this structure directs the current to flow between the source region 15 and the drain region 17, that is, to flow in the direction along the main surface of the n-type substrate 11. Therefore, the MESFET 30 has a horizontal structure. Consequently, as shown in Embodiment 3 of the present invention, the n-type substrate 11 is prepared so as to be in the direction at which the minimum angle between its main surface and a plane perpendicular to the (0001) plane is one degree or less, for example, in the direction at which the minimum angle between the main surface and the [0001] direction, which is perpendicular to the (0001) plane, is one degree or less. As a result, in comparison with the case where the preparation is performed in such a way that the main surface is in the direction along the (0001) plane, the values of the insulation breakdown electric field, breakdown voltage, and electron mobility can be increased and the value of the on-resistance can be decreased, as described before.

Embodiment 3 is different from Embodiment 1 of the present invention only in the above-described features. More specifically, the structure, conditions, production steps, and so on all not described in the explanation of Embodiment 3 of the present invention are in conformance with those of Embodiment 1 of the present invention.

### EMBODIMENT 4

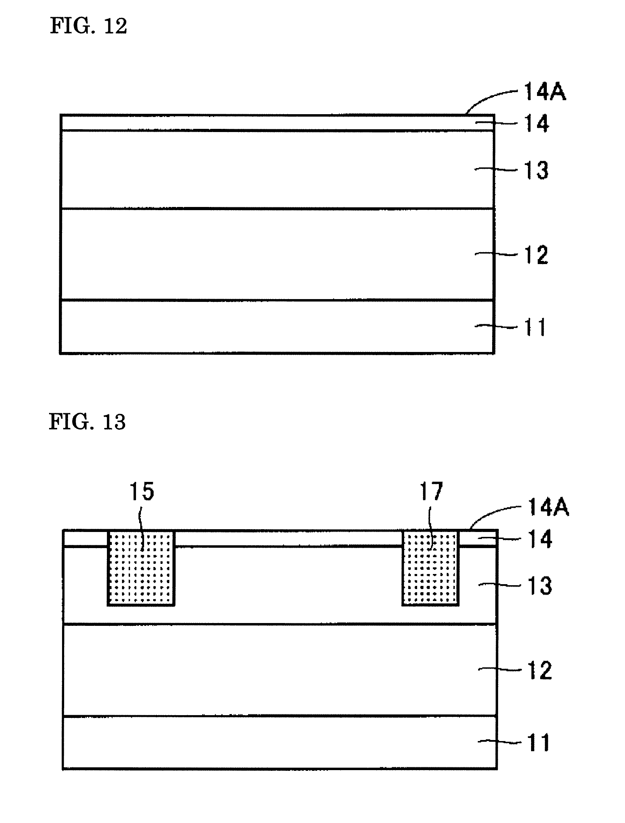

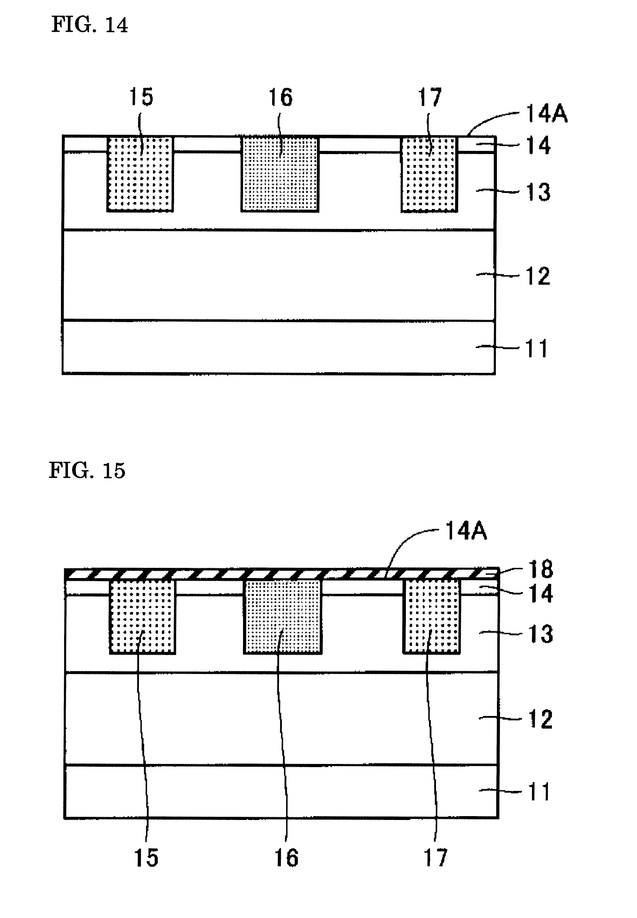

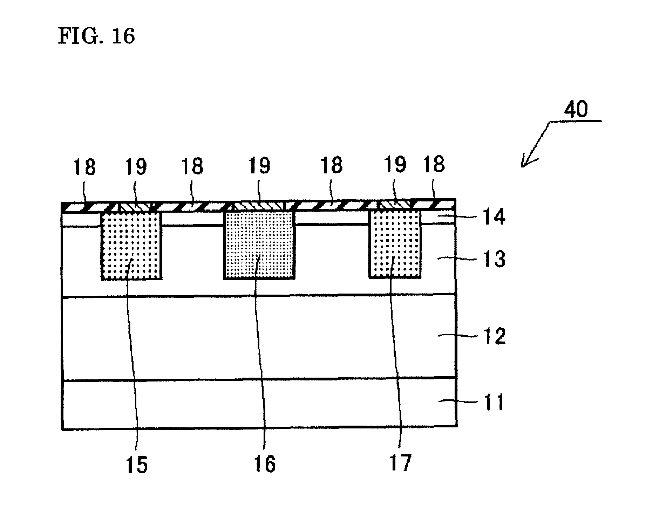

Figure 12 is a schematic diagram, for Embodiment 4 of the present invention, showing the state after performing a step (S10) and a step (S20) shown in the flowchart in Fig. 1. Figure 13 is a schematic diagram, for Embodiment 4 of the present invention, showing the state after performing a step (S30) shown in the flowchart in Fig. 1. Figure 14 is a schematic diagram, for Embodiment 4 of the present invention, showing the state after performing a step (S40) shown in the flowchart in Fig. 1. Figure 15 is a schematic diagram, for Embodiment 4 of the present invention, showing the state after performing a step (S60) shown in the flowchart in Fig. 1. Figure 16 is a schematic diagram, for Embodiment 1 of the present invention, showing the state after performing a step (S70) shown in the flowchart in Fig. 1.

Embodiment 4 of the present invention shows the method of producing a horizontal RESURF-JFET 40 shown in Fig. 16 among semiconductor devices. As shown in Fig. 16, in the horizontal RESURF-JFET 40, a thin second p-type semiconductor layer 14 is further formed on the n-type semiconductor layer 13 through epitaxial growth. The source region 15, the gate region 16, and the drain region 17 are formed so as to pass through the second p-type semiconductor layer 14 and penetrate into the n-type semiconductor layer 13 to a certain depth from one main surface of the second p-type semiconductor layer 14 (see Figs. 14 to 16). This structure enables the achievement of a uniform distribution of the electric-field strength in the region between the gate region 16 and the drain region 17 and therefore the suppression of the field concentration. The presence of the second p-type semiconductor layer 14 enables the reduction of the parasitic resistance at the inside of the semiconductor device. The horizontal RESURF-JFET 40 is different from the horizontal JFET 10 in Embodiment 1 of the present invention only in the above-described features.

In the method of producing the horizontal RESURF-JFET 40 in Embodiment 4 of the present invention, in the epitaxial growth step (S20), after the formation of the n-type semiconductor layer 13, the second p-type semiconductor layer 14 is formed on the n-type semiconductor layer 13 through epitaxial growth. In the first ion implantation step (S30) and the second ion implantation step (S40), resist application, exposure to light, and development are performed so as to form the source region 15, the gate region 16, and the drain region 17 in such a way that they pass through the second p-type semiconductor layer 14 and penetrate into the n-type semiconductor layer 13 to a certain depth from the one main surface of the second p-type semiconductor layer 14. In the oxide-film-forming step (S60), an oxide film 18 composed of silicon dioxide (SiO₂) is formed as a field oxide film so as to cover the top surface 14A of the second p-type semiconductor layer 14. The method of producing the RESURF-JFET 40 is different from the previously described method of producing the JFET 10 in Embodiment 1 of the present invention only in the above-described features.

Embodiment 4 is different from Embodiment 1 of the present invention only in the above-described features. More specifically, the structure, conditions, production steps, and so on all not described in the explanation of Embodiment 4 of the present invention are in conformance with those of Embodiment 1 of the present invention.

### Example 1

In the following, the present invention is explained further concretely by referring to Examples. Nevertheless, the present invention is not limited by these Examples.

In the following individual Examples, the evaluation is conducted by producing the previously described JFET 10 in Embodiment 1 of the present invention. Consequently, the explanation is given by referring to Figs. 1 to 6 as needed.

The method of forming the JFET 10 as Example 1 is explained below. First, the substrate-preparing step (S10) shown in Fig. 1 is performed. The substrate is a semiconductor having a hexagonal crystal. An SiC wafer as the substrate is prepared so as to be in the direction at which the minimum angle between its main surface and a plane perpendicular to the (0001) plane is one degree or less, for example, in the direction at which the minimum angle between the main surface and, for example, the [0001] direction, which is perpendicular to the (0001) plane, is one degree or less. It is desirable that the SiC be a polycrystalline type known as 4H-SiC. An SiC wafer is prepared that has an n-type conduction type and that has a main surface formed of a plane equivalent to the (11-20) plane as the crystal plane having a main surface that is in the direction at which the minimum angle between the main surface and the [0001] direction is one degree or less (the wafer corresponds to the n-type substrate 11 in Figs. 2 to 6). In the epitaxial growth step (S20) shown in Fig. 1, on one main surface of the n-type semiconductor layer 11, a p-type semiconductor layer 12 having a thickness of 10 µm and a p-type dopant concentration of 1 × 10¹⁶ cm⁻³ and an n-type semiconductor layer 13 having a thickness of 0.7 µ m and an n-type dopant concentration of 1 × 10¹⁷ cm⁻³ are successively formed through epitaxial growth.

Next, in the first ion implantation step (S30) shown in Fig. 1, the ion implantation of P is performed to form a source region 15 and a drain region 17 both having a depth of 0.5 µm from the surface of the n-type semiconductor layer 13 and a dopant concentration of 5 × 10¹⁸ cm⁻³. In the second ion implantation step (S40) shown in Fig. 1, the ion implantation of Al is performed to form a gate region 16 having a depth of 0.4 µm from the surface of the n-type semiconductor layer 13 and a dopant concentration of 2 × 10¹⁸ cm⁻³.

Next, in the activation annealing step (S50) shown in Fig. 1, the SiC wafer under the process of forming the JFET 10 is heated at 1,700°C for 30 minutes in an Ar gas atmosphere. In the oxide-film-forming step (S60) shown in Fig. 1, the SiC wafer under the process of forming the JFET 10 is heated at 1,300°C for 60 minutes in an oxygen gas atmosphere to form an oxide film 18 as a field oxide film. In the ohmic-electrode-forming step (S70), first, the oxide film 18 (the field oxide film) on the source region 15, the gate region 16, and the drain region 17 is removed. Then, by vapor-depositing, for example, Ni, an Ni layer as the ohmic electrode 19 is formed on the top surface of the source region 15, the gate region 16, and the drain region 17. Through the above-described procedure, the JFET 10 as Example 1 of the present invention is formed. Example 2

The method of forming the JFET 10 as Example 2 is explained below. First, the substrate-preparing step (S10) shown in Fig. 1 is performed. The substrate is a semiconductor having a hexagonal crystal. An SiC wafer as the substrate is prepared so as to be in the direction at which the minimum angle between its main surface and a plane perpendicular to the (0001) plane is one degree or less, for example, in the direction at which the minimum angle between the main surface and, for example, the [0001] direction, which is perpendicular to the (0001) plane, is one degree or less. In the method of forming the JFET 10 as Example 2, an SiC wafer is prepared that has an n-type conduction type and that has a main surface formed of a plane equivalent to the (1-100) plane as the crystal plane having a main surface that is in the direction at which the minimum angle between the main surface and the [0001] direction is one degree or less (the wafer corresponds to the n-type substrate 11 in Figs. 2 to 6). The JFET 10 as Example 2 is different from the JFET 10 as Example 1 only in the above-described features. More specifically, the structure, conditions, production steps, and so on all not described in the explanation of the method of forming the JFET 10 as Example 2 are in conformance with those of the method of forming the JFET 10 as Example 1.

### COMPARATIVE EXAMPLE

An explanation is given below to the method of forming a JFET as Comparative example in comparison with the above-described JFETs 10 as Examples 1 and 2 formed in accordance with Embodiment 1 of the present invention. First, the substrate-preparing step (S10) shown in Fig. 1 is performed. The JFET as Comparative example includes a semiconductor material having a hexagonal crystal. An SiC wafer as the substrate (see the n-type substrate 11 in Figs. 2 to 6) is prepared so as to be in the direction at which the minimum angle between its main surface and a direction parallel to the (0001) plane is eight degrees. The JFET as Comparative example is different from the JFET 10 as Example 1 only in the above-described feature. More specifically, the structure, conditions, production steps, and so on all not described in the explanation of the method of forming the JFET as Comparative example are in conformance with those of the method of forming the JFET 10 as Example 1.

As described above, the following JFETs were formed under all other conditions are same:
(a) the JFETs 10 as Examples 1 and 2 each having a substrate formed so as to have a crystal plane in accordance with the embodiment of the present invention, and
(b) the JFET as Comparative example in which the substrate's main surface is in the direction along the (0001) plane in accordance with the conventional practice.
   The individual JFETs were subjected to measurements of the breakdown voltage and the on-resistance. In the above description, the breakdown voltage is the maximum voltage that can be applied between the ohmic electrode on the source region and the ohmic electrode on the drain region and is expressed in the unit volt (V). The on-resistance is the electrical resistance between the ohmic electrode on the source region and the ohmic electrode on the drain region during the time of the on-state in which the JFET is driven by causing a current to flow between the source region and the drain region through the application of a voltage to the ohmic electrode on the gate region. Table I below shows the results of the measurements.

**Table I**

| | Breakdown voltage (V) | Ratio of break-down voltage | Ratio of on-resistance |
|---|---|---|---|
| Example 1 | 275 | 1.62 | 0.83 |
| Example 2 | 280 | 1.65 | 0.85 |
| Comparative example | 170 | 1 | 1 |

As can be seen from the results shown in Table I, both of Examples 1 and 2 improve the magnitude of the breakdown voltage over Comparative example by more than 100 V. When the magnitude of breakdown voltage of Comparative example is taken as 1, both of Examples 1 and 2 have a magnitude of breakdown voltage of more than 1.6. When the magnitude of on-resistance of Comparative example is taken as 1, the on-resistance of Example 1 is 0.83 and that of Example 2 is 0.85. This result shows that the on-resistance is also significantly improved. The above results show that because the horizontal semiconductor device is formed such that the SiC substrate is in the direction intersecting the (0001) plane, the value of breakdown voltage is increased and the value of on-resistance is decreased in comparison with the conventional case where the semiconductor device is formed such that the SiC substrate is in the direction along the (0001) plane. As described above, by forming a horizontal semiconductor device such that its SiC substrate is in the direction intersecting the (0001) plane, for example, in the direction at which the minimum angle between its main surface and a plane perpendicular to the (0001) plane is one degree or less, the values of the insulation breakdown electric field, breakdown voltage, and on-resistance can be considerably improved. In a horizontal semiconductor device, a current flows in the direction along the main surface of the substrate, showing that an electric field is applied. The values of the breakdown voltage and the electron mobility in the direction along the main surface of the substrate can be increased. Consequently, it is likely that when a semiconductor device is formed in such a way that the SiC substrate is in the direction intersecting the (0001) plane, for example, in the direction at which the minimum angle between its main surface and a plane perpendicular to the (0001) plane is one degree or less, even the allowable value of the current can be increased, for example.

It is to be considered that the above-disclosed embodiments and examples are illustrative and not restrictive in all respects. The scope of the present invention is shown by the scope of the appended claims, not by the above-described embodiments. Accordingly, the present invention is intended to cover all revisions and modifications included within the meaning and scope equivalent to the scope of the claims.

### Industrial Applicability

The method of the present invention for producing a semiconductor device is excellent as a technique for improving the breakdown voltage and the on-resistance.

## Claims

1. A semiconductor device, comprising:
(a) a substrate that is composed of hexagonally crystalline silicon carbide and that has a main surface forming a minimum angle of one degree or less with respect to a plane perpendicular to the (0001) plane;
(b) a semiconductor layer placed on one main surface of the substrate;
(c) a source region formed in one surface layer of the semiconductor layer; and
(d) a drain region formed in the surface layer of the semiconductor layer so as to be separated from the source region with some distance.

2. The semiconductor device as defined by claim 1, wherein the main surface of the substrate forms a minimum angle of one degree or less with respect to a plane equivalent to the (11-20) plane.

3. The semiconductor device as defined by claim 1, wherein the main surface of the substrate forms a minimum angle of one degree or less with respect to a plane equivalent to the (1-100) plane.

4. The semiconductor device as defined by any one of claims 1 to 3, the device further comprising a gate region in the surface layer existing between the source region and the drain region both on the one main surface of the semiconductor layer.

5. The semiconductor device as defined by any one of claims 1 to 3, the device further comprising:
(a) a gate-insulating film in the surface layer existing between the source region and the drain region both on the one main surface of the semiconductor layer; and
(b) a gate electrode on one main surface of the gate-insulating film.

6. The semiconductor device as defined by any one of claims 1 to 3, the device further comprising a gate electrode on the surface layer existing between the source region and the drain region both on the one main surface of the semiconductor layer, the gate electrode being in Schottky contact with the semiconductor layer.

7. A method of producing a semiconductor device, the method comprising the steps of:
(a) preparing a substrate that is composed of hexagonally crystalline silicon carbide and that has a main surface forming a minimum angle of one degree or less with respect to a plane perpendicular to the (0001) plane;
(b) forming a semiconductor layer placed on one main surface of the substrate; and
(c) forming a source region formed in one surface layer of the semiconductor layer and a drain region formed in the surface layer of the semiconductor layer so as to be separated from the source region with some distance.

8. The method of producing a semiconductor device as defined by claim 7, wherein the main surface of the substrate forms a minimum angle of one degree or less with respect to a plane equivalent to the (11-20) plane.

9. The method of producing a semiconductor device as defined by claim 7, wherein the main surface of the substrate forms a minimum angle of one degree or less with respect to a plane equivalent to the (1-100) plane.

10. The method of producing a semiconductor device as defined by any one of claims 7 to 9, the method further comprising a step of forming a gate region in the surface layer existing between the source region and the drain region both on the one main surface of the semiconductor layer.

11. The method of producing a semiconductor device as defined by any one of claims 7 to 9, the method further comprising the steps of:
(a) forming a gate-insulating film in the surface layer existing between the source region and the drain region both on the one main surface of the semiconductor layer; and
(b) forming a gate electrode on one main surface of the gate-insulating film.

12. The method of producing a semiconductor device as defined by any one of claims 7 to 9, the method further comprising a step of forming a gate electrode on the surface layer existing between the source region and the drain region both on the one main surface of the semiconductor layer, the gate electrode being to be in Schottky contact with the semiconductor layer.
